# EUROPEAN PATENT APPLICATION

(11) **EP 0 546 190 A1**
(43) Date of publication of application: **16.06.1993**
(21) Application number: 92912873.4
(22) Date of filing: 22.06.1992
(51) Int. Cl.: G03D 13/00, G03B 27/32

(54) **IMAGE FORMATION APPARATUS**

(30) Priority: 27.06.1991 JP 156425/91; 12.12.1991 JP 328895/91; 12.12.1991 JP 102547/91 U
(71) Applicant: SEIKO EPSON CORPORATION, Shinjuku-ku Tokyo 163 (JP); SEIKO INSTRUMENTS INC., Tokyo 136 (JP)
(72) Inventor: FUJITA, Toru, Suwa-shi, Nagano-ken 392 (JP); MOMOSE, Kiyoharu, Suwa-shi, Nagano-ken 392 (JP); SUZUKI, Takashi, Suwa-shi, Nagano-ken 392 (JP)
(74) Representative: Hoffmann, Eckart, Dipl.-Ing.
(86) International application number: PCT/JP92/00797
(87) International publication number: WO 93/00613

(57) **Abstract**

An image formation apparatus using a photosensitive member having heat developability, in which process control is performed over a period from heat development to pressure transfer to form an image under a stable condition without effects of ambient temperature and the condition of use of the apparatus. To this end, it is very effective to detect temperature and humidity during a period from heat development to pressure transfer, and to control the temperature and heating time for heat development or to stabilize the temperature of the photosensitive member after heat development till pressure transfer, and particularly to make cooling below a predetermined temperature. It is preferred, as the cooling method, (1) to make cooling below a temperature which is 50 _{°} C higher than pressure transfer temperature, and (2) to start cooling within 10 seconds after completion of heat development. As a specific cooling mechanism, preferred is an air cooling method using cooling rollers (59,74), fans (60,63,72), etc. Alternatively, a water cooling method using a cooling roller (76) may be employed.

## Description

### [TECHNICAL FIELD]

The present invention relates to an image formation apparatus utilizing a transfer type photosensitive heat developable member to form images of a copying machine, a printer or the like. More particularly, it relates to a control of process from heat developing to pressure transfer.

### [BACKGROUND ART]

Various kinds of methods and apparatuses for forming images have been known. A conventional image formation apparatus utilizing a transfer type photosensitive heat developable member is disclosed in, for example, Japanese Laid-Open No. 62-147461. According to this publication, main mechanism portions, such as an exposure portion, a heat development portion and a pressure transfer portion, are arranged in one structure of the apparatus. Image formation is performed according to the following procedure.

First, the roll-type transfer type photosensitive heat developable member is cut in predetermined lengths before an image is exposed to form a latent image. Next, the heat development portion develops the latent image by heat rollers. Then, a photosensitive member is superposed by image-receiving paper, and is transferred under pressure by rollers. The photosensitive member is discharged by a separation device to a disposal portion therefor, whereas the image-receiving paper is discharged to a tray through a fixing device.

Such a prior art is a color copying machine, which uses a photosensitive member wherein microcapsules including photosensitive materials, polymer compounds and color materials are coated on a supporting member, and a transfer member which receives the transfer of color materials from the photosensitive member under pressure. The development is performed in the heat developing section, so that the whole of microcapsules including the color materials is transferred from the photosensitive member to the image receiving paper by the pressure transfer section, thereby the images are copied.

The above prior art has superior features in that it is possible to obtain an image forming device of a low-cost and small-size and a high quality of images. However, the prior art has inferior features in that from the heat developing section, to the pressure transfer section, the circumference temperature and the humidity of the photosensitive members may be easily varied by the temperature of the image forming apparatus, thereby the hardness of the capsules may be varied, so that the quality of images is deteriorated, (that is, the density of images become unstable). In particular, when the ambient temperature is high, the density gets lower, and when the ambient temperature is low, the density gets higher.

Further, the other conditions are watched, for example, the density is gradually lowered according to the elapsed time after the power-on. Further, when the image is continuously output, the density of the output image is varied and the stable quality of images can not be obtained, and further a quality of images may be deteriorated, that is, the lowest density becomes higher, or the highest density becomes lower.

In addition to the above, as the other factor the following condition was watched. Namely, the dispersion of densities gets larger according to the difference of the devices. The present invention is to eliminate the above problems, and its object is to provide an image formation apparatus wherein images of a high quality are output, that is, the obtained density is uniform and the quality of images are stable.

### [Description of the Invention]

In the image forming apparatus of the present invention wherein a photosensitive, heat developable member is pressed together with a transfer member by a pressure transfer device after the heat developing of the heat developable member by the heat developing device, the image formation apparatus comprises means for changing at least one of the temperature of the heat developing device and the heating time, and means for detecting at least one of the temperature and the humidity between the heat developing device and the pressure transfer device, wherein at least one of the temperature and the heating time of the heat developing device is controlled according to the data from the detecting means.

Otherwise, the image forming apparatus has further specific features in that means for controlling the temperature of the photosensitive member is provided between the heat developing device and the pressure transfer device, to get the temperature uniform, and in particular, cooling means is provided between the heat developing device and the pressure transfer device, to get the photosensitive member below a predetermined temperature.

The inventors found that in the above two compositions, the latter, that is, the temperature of the photosensitive member from the heat developing to pressure transfer is highly effective for preventing the deterioration of images. (Hereinafter, this is described in detail.)

Thereupon, the image forming apparatus of the present invention has the specific feature that the cooling means are provided for cooling the photosensitive member below the temperature of the pressure transfer plus 50 °C after the heat developing. Otherwise, the image forming apparatus of the present invention has the specific feature the cooling means is started to cool the photosensitive member within 10 seconds after the photosensitive member is completely heated by the heat developing device.

The concrete composition of the cooling means is as follows. The cooling means is an air cooling type, and the cooling means rotates in accordance with the moving of the photosensitive member. It is desirable that the path of the cooling air is provided so that the cooling air does not affect against the air of the heating area. Otherwise, the cooling device may be a water cooling device, and has a specific feature in that the cooling liquid may be circulated in the hollow.

The photosensitive member used in the present invention is heat-developed after exposure, thereby the micro capsules may be hardened according to the degree of the exposure, and the color agent is transferred to the transfer member by the pressure transfer to form images. The inventors have earnestly examined a series of processes, and, as a result, the proceeding of the hardness of the micro capsules is not only affected by the temperature of the heat developing treatment and the heating time, but also affected by the temperature and humidity from the heat developing until the pressure transfer.

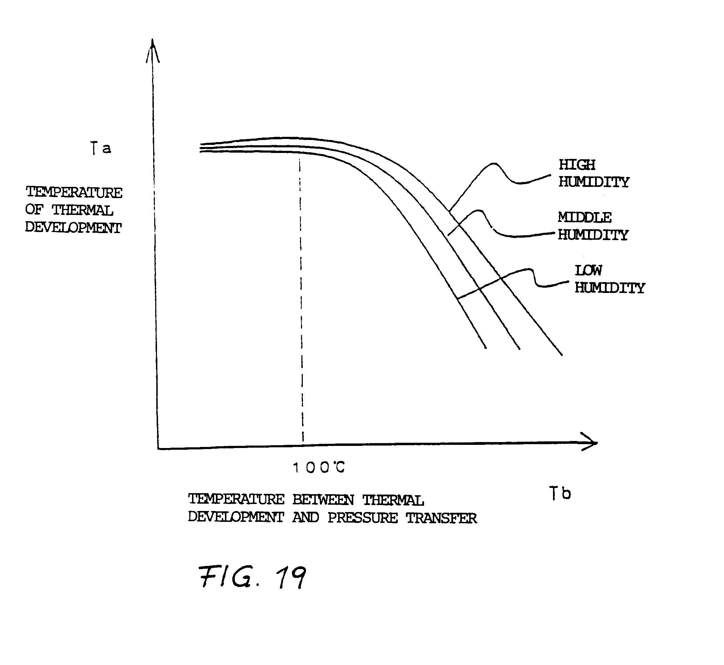

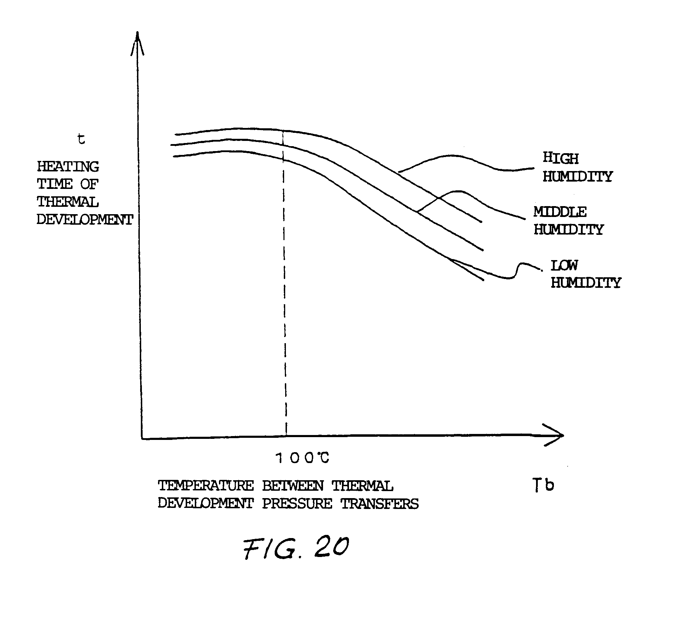

In general, with respect to the degree of the hardness of the micro capsules, there is an appropriate range. If the degree is outside the appropriate range, some problems may occur, that is, the output image may be deteriorated, for example, the lowest density is very high, the highest density is very low, the graduation may be inferior, and a color difference may be generated. Fig. 19 is a graph showing the change of the heat developing treatment temperature Ta to obtain an appropriate proceeding of the capsule hardness with respect to the temperature Tb from the heat developing until the pressure transfer, when the heating time is uniform. In the graph, a plurality of curve lines are drawn according to the humidity from the heat developing until the pressure transfer. Fig. 20 is a graph showing the change of the heating time to obtain appropriate proceeding of the capsule hardness with respect to the temperature Tb from the heat developing until the pressure transfer. In the same way as Fig. 19, a plurality of curve lines are drawn according to the humidity. The present invention, basically utilizing the relation between them, controls the heat developing treatment temperature, the heating time, and the temperature from the heat developing until the pressure transfer, to obtain a stable image.

The inventors have examined the above mentioned problems and, as a result, the image deterioration may be much affected by the difference of the lowering ways of the temperature of the photosensitive member after the heat developing. In general, with respect to the photosensitive member of the heat developing type, the excellent density rendering may be obtained by only controlling the temperature of the heat developing time within the appropriate range. Therefore, the temperature of the heat developing device is accurately controlled based on the detecting temperature from the temperature detector. In spite of this, as if the developing temperature of the heat developing device was outside the appropriate range, the image of the density rendering was obtained. The inventors had an insight that the heat developing reaction may proceed in the process that after the heat developing device, the temperature of the photosensitive member continuously decreases from the heat developing temperature and the reaction inside the photosensitive member proceeds further. As a result of the experiments, the inventors found that the degree of the developing may be much changed according to the way the temperature is lowered after the heat developing. Therefore, the temperature of the photosensitive member is different according to the ambient temperature, the temperature of the peripheral portions in the device, the air flowing within the device, and so on, so that the density rendering is unstable.

When the image is continuously output, the pressure transfer device is heated by passing the heated photosensitive member, so that a raising temperature of the pressure transfer device was found. When the temperature of the pressure transfer device is changed, it is assumed that the characteristic of material such as the viscosity of the micro capsules transferred from the photosensitive member to the transfer member is changed and the density of the transferred image and the image quality may be changed.

In the process of the above analysis, if a cooling means for cooling the photosensitive member heated in the heat developing device is provided and the cooling condition of the photosensitive member is appropriate, even if the ambient temperature is changed, stable and high quality image can be obtained, and the inventors have confirmed that the rising degree of the temperature of the pressure transfer device heated by the continuous image output is very small.

It is assumed that these effects are obtained by the following. Namely, a stable and uniform transfer can be performed by controlling the rising temperature of the pressure transfer device, when the temperature of the photosensitive member carried to the pressure transfer device is a predetermined temperature or below. Further, a developing reaction is controlled within a predetermined range by controlling the temperature of the photosensitive member within the range of a predetermined range in the path of the photosensitive member after the completion of the heating by the developing device until the pressure transfer device, and further by shortening the heated path where the developing reaction rapidly proceeds.

[Brief Description of the Drawings]
Fig. 1 is a front cross-sectional view showing the whole of an analogue copying machine according to a first embodiment of the present invention;
Fig. 2 is a front cross-sectional view showing the first embodiment according to the present invention;
Fig. 3 is a block diagram showing the circuit of Fig. 2;
Fig. 4 is a view showing an algorithm of the one embodiment;
Figs. 5, 6, and 7 are front cross-sectional views showing an improved embodiment of the first embodiment, and relate to several methods for controlling the heat developing time:
Fig. 8 is a front cross-sectional view showing a second embodiment according to the present invention;
Figs. 9 and 10 are a front cross-sectional view and a perspective view showing an improved embodiment of the second embodiment;
Fig. 11 is a front cross-sectional view showing a third embodiment according to the present invention;
Fig. 12 is a conception view showing the variety of temperatures of the photosensitive member according to the third embodiment;
Figs. 13(a) and 13(b) are a front cross-sectional view and a perspective view showing the concrete composition of the third embodiment;
Figs. 14 to 17 are cross-sectional views showing an improved embodiment of the third embodiment, and Figs. 14 to 16 are an embodiment of an air cooling type, and Fig. 17 is an embodiment of a water cooling type. Further, Fig. 18 is a cross-sectional view of the cooling plate according to the other embodiment of the cooling means;
Figs. 19 and 20 are a conception view showing the specific feature of the photosensitive member which is used for the present invention.

### (Description of the reference numerals)

1 Manuscript
2 Manuscript platen
3 Cover of Manuscript
4 lamp
5 reflector
6 lens
7 Exposure stand
8 photosensitive member
9, 10 carrying roller
11 heat developing roller
12 upper transfer roller
13 lower transfer roller
14 transfer member
15 paper supply tray
16 paper supply roller
17 separate roller
18 pinch roller
19 discharge roller
20 supply roll
21 wind-up roll
22 discharge tray
41 heater
42 switch
43, 44 thermistor
45 humidity detecting means
46 central possessing unit (CPU)
47a, b, c A/D converter
48, 49, 50 supplemental roller
51 plate
52 uniform temperature roller
53, 60, 63, 72 fan
54 uniform temperature plate
55 heating means
56 cooling means
57 temperature detecting means
58 box
59, 74, 76 cooling roller
61 shielding plate
62 heat removing roller
64 frame
65 first bearing
66 second bearing
67 first air duct
68 second air duct
69, 79 outer case
70, 71, 80 opening
75 blade
77 pipe
78 pump
81 radiator
82 fin
83 cooling plate

### [Best Mode of Carrying out the Invention]

The present invention will be described below in detail in accordance with the embodiments.

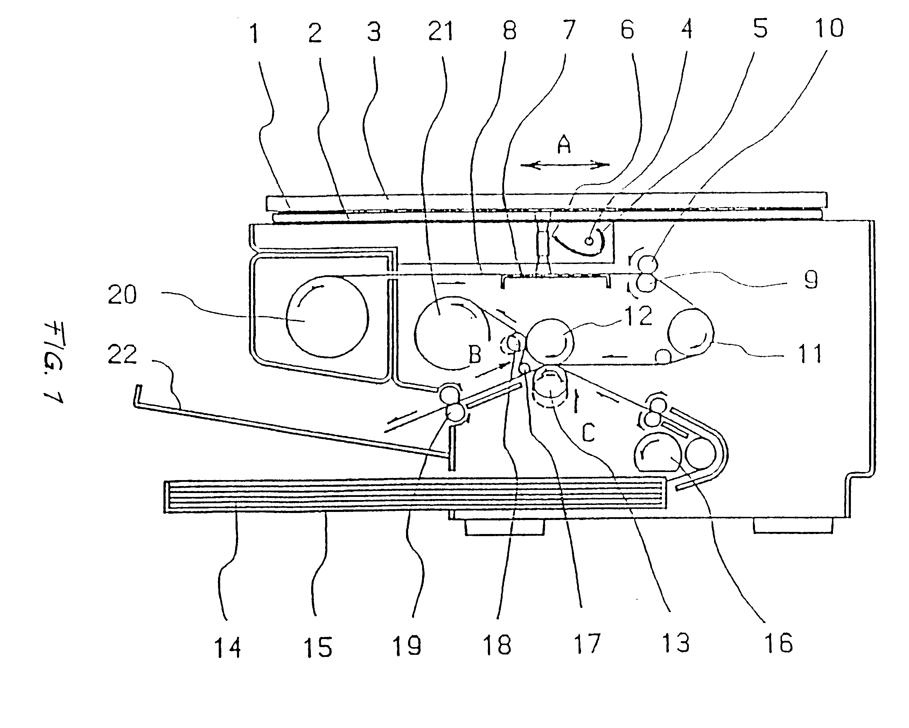

Fig. 1 is a front cross-sectional view of a whole construction, when the image formation apparatus of the present invention is used for an analogue copying machine.

In Fig. 1, once a copy operation begins, the manuscript platen 2 onto which the manuscript 1 is placed and the manuscript cover 3 move to an exposure start position on the left hand side of the drawing. Scanning begins in a direction indicated by arrow A. At the same time, the carrying rollers 9 and 10 rotate and the unused photosensitive member 8 is nippedly carried on and drawn from the supply roll 20, whereby the photosensitive member 8 is carried synchronously with the scanning of the manuscript.

At this point, the light source 4 is lit and the light gathered by the reflector 5 is irradiated on the manuscript 1 and then the latent image of the manuscript 1 is formed through the lens 6 onto the photosensitive member 8 on the exposure stand 7.

At the substantially same time as the start of the carrying operation of the carrying rollers 9 and 10, an upper transfer roller 12 rotates and the pinch roller 18 is moved in the direction of the arrow B so as to be pressed toward the upper transfer roller 12, thereby the photosensitive member 8 on which the latent image is formed is carried toward the heat developing device 11, so that the image is developed by the contact heat between the heat developing roller 11 and the photosensitive member 8.

After the heat developing operation, when the front edge of the image record on the photosensitive member approaches near one of rollers of the pressure transfer device, that is, the upper roller 12, the transfer member 14 is supplied from the supply tray 15 by the supply roller 16, and is superposed on the image area on the photosensitive member, and then the other roller of the pressure transfer device, the lower roller 13 is moved in the direction of the arrow C, thereby they are pressed between the upper transfer roller 12 and the lower transfer roller 13, so that the image on the photosensitive member 8 is transferred to the transfer member 14. After transfer, the photosensitive member 8 is separated by a separation roller 17 from the transfer member 14, being withdrawn onto the wind-up roll 21 via the pinch roller 18. After exposure scanning has been completed, the light source 1 goes off and the manuscript platen 2 onto which the manuscript is placed and the manuscript cover 3 goes back to the center portion of the device.

When the pressure transfer has been completed to the end of the image, the lower transfer roller 13 is moved toward the lower portion. After that, the carrying rollers 9 and 10 stop and the pinch roller 18 is also separated from the upper transfer roller 12 and the photosensitive member 8 stops. Thereby, the transfer member 14 on which the pressure transfer is completed is discharged to the discharge tray 22, then a series of operation has been finished.

Next, a series of processes from the heat developing to the pressure transfer, that is, the specific feature of the present invention, is explained.

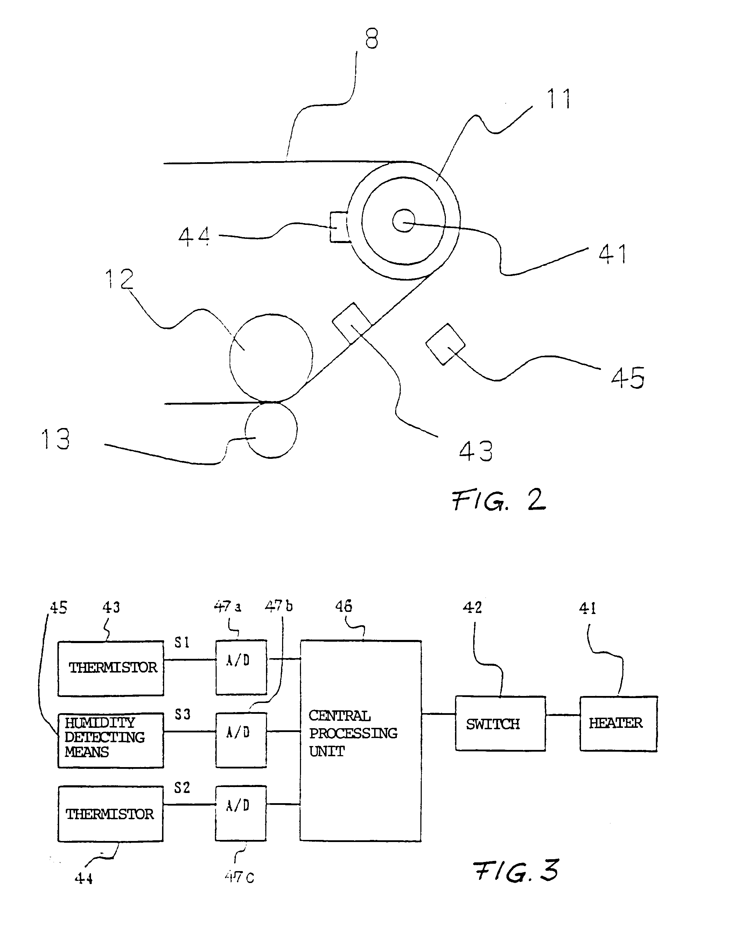

The construction for detecting the temperature and humidity between the heat developing and the pressure transfer and controlling the heat developing temperature is described with reference to Fig. 2.

Fig. 2 is a front cross-sectional view near the heat developing roller 11 and the pressure transfer rollers 12 and 13. In the embodiment, a heater 41 formed inside the hollow heat developing roller 11 and a switch 42 for turning on/off the heater 41 (not shown) are provided as means for changing the temperature of the heat developing device. In the embodiment, a halogen lamp is used as a heater 41. Heater for turning on/off by the outer switch, for example, a nichrome wire and switch extreme infrared rediation heater can be used. A temperature detecting means using a thermistor 44 is provided so as to slidably contact the surface of the heat developing roller 11 and to monitor the surface temperature of the heat developing roller 11. It is possible to omit the thermistor 44, if the temperature of the heat developing device can be determined based on the relationship between the power on/off operation of the heater and the temperature of the heat developing device.

On the contrary, the thermistor 43, the other temperature detecting means, is provided so as to be brought in slidable contact with the rear surface of the photosensitive member 8, thereby the temperature between the heat developing device and the pressure transfer device is detected. Besides the thermistor, a platinum temperature sensor, a thermocouple and so on can be used. If the distance between the thermistor 43 and the photosensitive member 8 is 50 mm or below, the thermistor may not be brought in contact with the photosensitive member 8. If the thermistor 43 is provided at the rear surface of the photosensitive member 8, there is no limitation of the distance between the photosensitive member 8 and the thermistor. When the thermistor 43 is provided at the front surface of the photosensitive member 8, it is desirable that the distance between the thermistor 43 and the photosensitive member 8 is above 0.5 mm and below 5mm, in order to avoid the contact of the thermistor with capsules coated on the surface of the photosensitive member. The humidity detecting means 45 is an impedance changeable type humidity sensor using a material of a high-polymer thin film sensitive to humidity. The humidity detecting means 45 is not brought in contact with the photosensitive member 8 and the distance between the humidity detecting means 45 and the photosensitive member 8 is within 50 mm, and it is fixed. As another humidity detecting means, the impedance changeable type humidity sensor using ceramic material sensitive to humidity and a static capacity changeable type humidity sensor can be used.

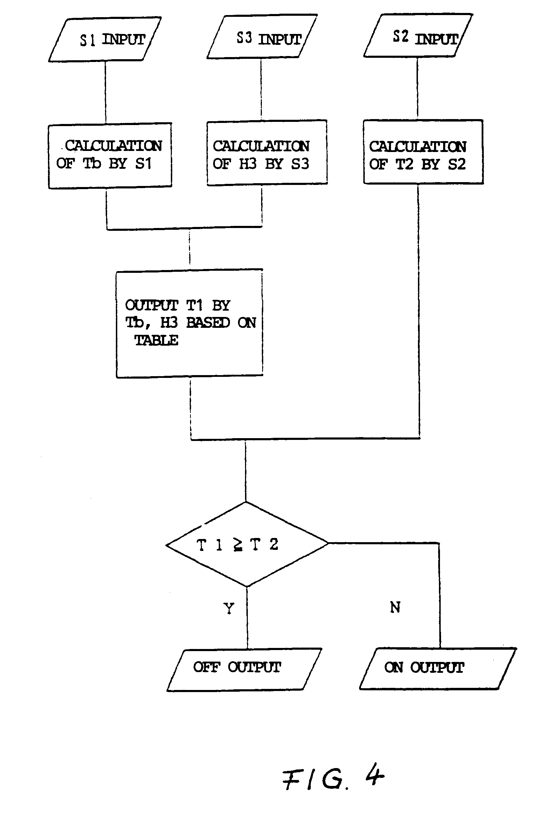

Fig. 3 is a block diagram showing a circuit which changes the temperature of the heat developing roller 11 by the data from the thermistor 43 and the humidity detecting means 45. Fig. 4 is a flowchart showing the flow of the processing of the central processing unit 46. The thermistor 43 transmits signal S1 which is output according to the detected temperature, to the central processing unit 46 through A/D convertor 47a, and the humidity detecting means 45 transmits signal S3 which is output according to the detected humidity, to the central processing unit 46 through A/D convertor 47b. Further, the thermistor 44 transmits signal S2 which is output according to the detected temperature through A/D convertor 47c to the central processing unit 46. The central processing unit 46 calculates the temperature Tb from S1 to the pressure transfer after the heat developing, and the humidity H3 of the same portion from S3, and the desirable temperature T1 of the heat developing roller is determined, in view of the specific relation in advance recorded in the inside memory. Next, as a result of the comparison between the temperatures T1 and T2 of the heat developing roller calculated from the signal S2 from the thermistor 44, whether the heater 41 turns on or off can be determined. The power on/off can be determined according to the following method. Namely, as shown in Fig. 4, when T1 =<T2, the heater is turned off and when T1>T2, the heater is turned on. Further, means for storing past data of temperature such as memory means may be also provided in order to enable a more complicated predictable control. Furthermore, besides the binary control of the power of the heater on/off, if many valued control is used with pulse width modulation, more accurate control such as duty control according to the difference between T1 and T2 can be conducted. There is a possibility that the humidity dependency and the temperature dependency of characteristic hardness of capsules is very low in accordance with the kinds of the used photosensitive member. When such a photosensitive member is used, it is needless to say that it is possible to omit such a humidity detecting means 45 and thermistor 43.

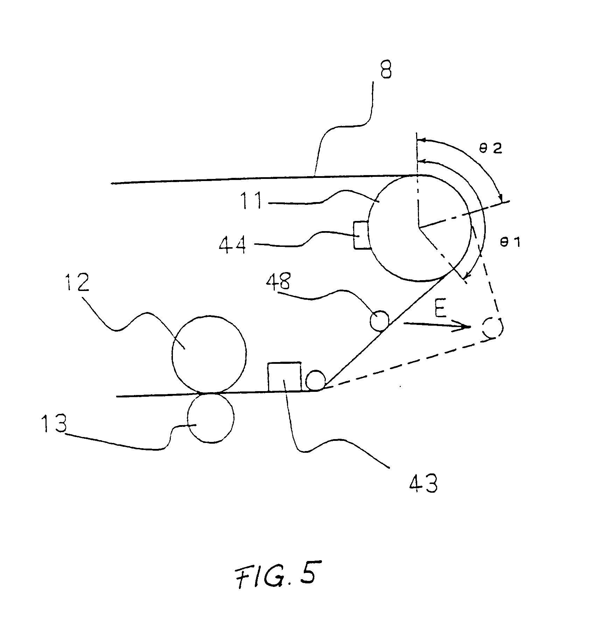

Fig. 5 shows a improved embodiment of the first embodiment of Fig. 2, being a front cross-sectional view near the heat developing roller 11 and the pressure transfer rollers 12 and 13. The embodiment has the specific feature that the temperature between the heat developing and the pressure transfer is detected in order to change the heating time of the heat developing device. A slidable supplemental roller 48 which is provided fulfills the function. The thermistor 43 is provided as the temperature detecting means between the heat developing and the pressure transfer in the same way as in the first embodiment. In the embodiment, the supplemental roller 48 is moved toward the direction of the arrow E in Fig. 5, and the angle between the heat developing roller 11 and the winding portion of the photosensitive member 8 can be varied from 01 to e2, and further the contact time between the heat developing roller 11 and the photosensitive member 8 can be varied. Since the heat transfer from the heat developing roller 11 to the photosensitive member 8 is not so much generated at the time of non-contact time, the contact time may equal to the heating time. As mentioned above, the heating time can be controlled by moving the supplemental roller 48. The supplemental roller 48 can be moved till a proper position by a driving means such as a motor (not shown). The winding angle can be changed according to the temperature detected by the thermistor 43 so that the photosensitive member can be heated for an appropriate time in view of the relation shown in Fig. 20. The heating time can be changed by other methods. The following is one embodiment.

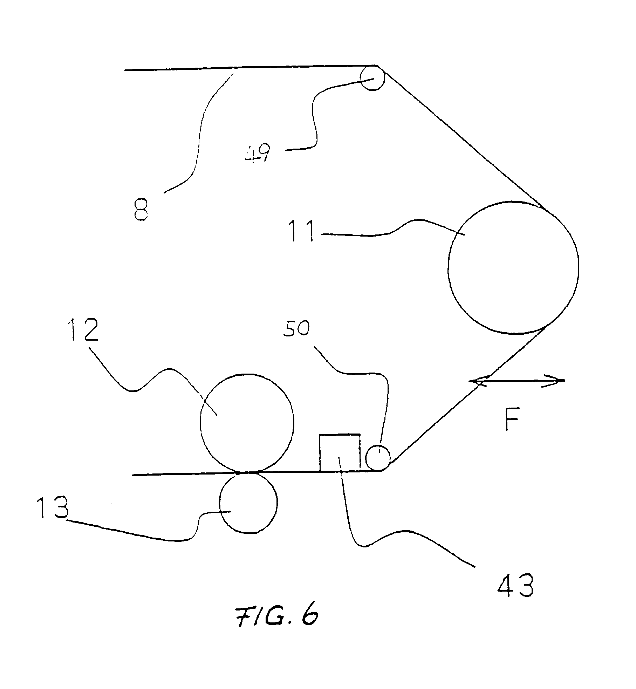

Fig. 6 is a front cross-sectional view showing another method for changing the heating time. The heat developing roller 11 is moved toward the arrow F shown in Fig. 6 against the fixed supplemental rollers 49 and 50, thereby the winding angle can be changed and the heating time can be changed.

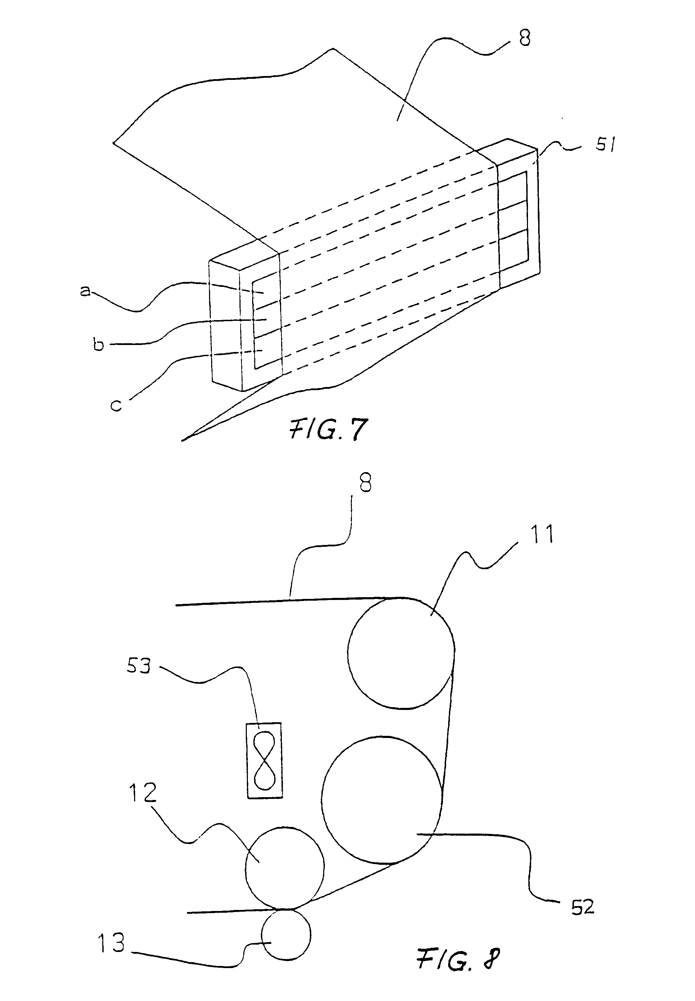

Fig. 7 shows a heat developing device employing a plate 51. The heating section is divided in two or more portions. The heating time can be changed by switching the divided heating portions respectively. The plate 51 has three heating portions a, b and c. The divided number is determined by the selecting count of a desired heating time.

As mentioned above, the first embodiment is an embodiment for controlling the temperature of the heat developing treatment and the heating time, respectively. It is needless to say that the control range of temperature and time, respectively, is narrowed by controlling both the temperature and the heating time, thereby the control can be simplified.

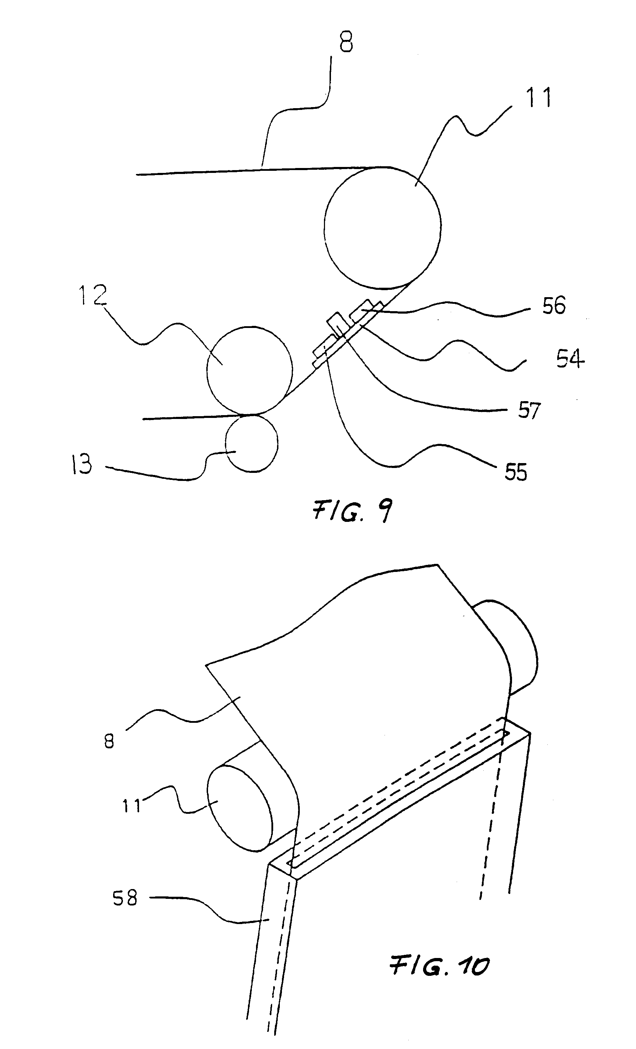

Next, the second embodiment of the present invention is explained. Fig. 8 is a front cross-sectional view showing the second embodiment. The second embodiment has the specific feature that the temperature of the photosensitive member between the heat developing and the pressure transfer be kept uniform.

In Fig. 8, the temperature uniforming roller 52 which is means for keeping the temperature of the photosensitive member 8 uniform, is brought in contact with the photosensitive member 8 between the heat developing roller 11 and the pressure transfer rollers 12 and 13. The temperature uniforming roller 52 is made of a material having a large heat capacity, for example, steel. Further, a fan 53 is provided for cooling the photosensitive member 8 to keep the temperature uniform. Since the heat capacity of the photosensitive member 8 is much smaller than the temperature uniforming roller 52, the temperature of the photosensitive member 8 is changed to the temperature of the uniform temperature roller, immediately after the heat developed photosensitive member 8 comes in contact with the temperature uniforming roller 52. In the embodiment, the temperature of the temperature uniforming roller 52 is not monitored. However, in order to allow a broader range of ambient temperatures, the temperature detecting means such as a thermistor may be also provided for feedback control of the temperature. Furthermore, in the embodiment, although the temperature uniforming roller 52 is brought in contact with the rear surface of the photosensitive member 8, the temperature uniforming roller 52 may be also provided so as to be brought in contact with the front surface of the photosensitive member 8. In this case, the rotating speed of the roller is arranged so as to become the same as the moving speed of the photosensitive member and it is desirable to not only simplify the transmit of the heat but also prevent any damage which may be generated by friction between the surface of the photosensitive member and the surface of the roller. Furthermore, cushion material may be also provided at the surface of the roller in order to enhance the adhesion between the surface of the photosensitive member and the surface of the uniform temperature roller.

Stillmore, in the above second embodiment, the roller is used as means for getting the temperature uniform, but a belt may be also provided instead of the roller. The same effects can be obtained. In this case, the belt has a smaller heat capacity than that of the roller, therefore it is desirable to include a temperature detecting means in the belt to detect the temperature and cool the photosensitive member till a uniform temperature by a cooling fan.

Fig. 9 is a front cross-sectional view showing an improved embodiment of the second embodiment according to the present invention. The temperature uniforming plate 54 which is provided as means for keeping the temperature of the photosensitive member 8 uniform is brought in contact with the photosensitive member 8 on one or more faces. The photosensitive member 8 is transmitted from the heat developing device and then, comes in contact with the temperature uniforming plate 54 to keep the temperature of the photosensitive member 8 uniform, and further reaches the pressure transfer device. A heating means 55, a cooling means 56, and a temperature detecting means 57 are provided with the temperature uniforming plate 54. In the embodiment, an aluminum plate is used as a substrate. A heater including copper-nickel resistance wound around a mica substrate is used as a heating means 55, and an electronic cooling element utilizing the Peltier effect is used as a cooling means 56. A thermistor is used as a temperature detecting means 57. Besides aluminum, as a material for mechanical members, for example, steel, plastic may be also used. As the heating means 55, besides the above, a radiation heater such as a halogen lamp, reverse polarity of the electronic cooling element utilizing the Peltier effect may be also used. In particular, when the reverse polarity of the electronic cooling element is used, switching means for switching the straight/reverse polarities is added. The cooling means serves as the heating means by switching the switching means, therefore such heating/cooling means is available for low cost and small space. Besides the above electronic cooling element, a fan for injecting the air may be also used.

The temperature of the temperature uniforming plate 54 is controlled by the heating/cooling means so as to be below the temperature of the heat developing, and be a desirable temperature above the centigrade 50 degree. In the embodiment, the contact surface with the photosensitive member 8 of the temperature uniforming plate 54 is plate-shaped, but the contact surface may be also curve-shaped such as a cylindrical surface. Further, in the embodiment, the temperature uniforming plate 54 is brought in contact with the rear surface of the photosensitive member 8. However it may be brought in contact with the front surface of the photosensitive member 8, if the material of the temperature uniforming plate 54 is made of so low frictional material that the friction between the front surface of the photosensitive member 8 and the temperature uniforming plate 54 is very low.

The temperature uniforming plate 54 may be also provided a little apart from the photosensitive member so that the distance between the photosensitive member 8 and the temperature uniforming plate 54 be 10mm or below 10mm. In this case, the temperature uniforming plate 54 may be provided opposed to the front surface of the photosensitive member 8 or to the rear surface of the photosensitive member 8. Further, although the effect for keeping the temperature uniform is a little inferior, it is also possible to omit one of the heating means and the cooling means. Furthermore, in the embodiment, the temperature uniforming plate 54 is provided to the one surface of the photosensitive member 8, but the temperature uniforming plate 54 may be also provided on both surfaces.

Fig. 10 is a perspective view of the improved embodiment wherein the moving path of the photosensitive member 8 is surrounded by the box 58, showing one embodiment for easily keeping the temperature uniform. The box 58 is made of one general mechanical material such as iron substrate and, thereby prevents the flow of the air from touching the photosensitive member 8 in the device. The photosensitive member 8 is inserted to the box 58 immediately after the photosensitive member 8 is kept at a uniform temperature by the heat developing device. The surface of the box 58 opposing to the photosensitive members 8 is apart from the photosensitive member by 0.5mm to 50mm, and the desirable distance between the box 58 and the photosensitive member is more than 2mm and less than 5 mm. By such a distance, any damage given to the surface of the photosensitive member 8 is prevented. Further, the box 58 may cover at least one of the peripheral surfaces of the photosenstive members, and it is not necessary to cover all of the surfaces.

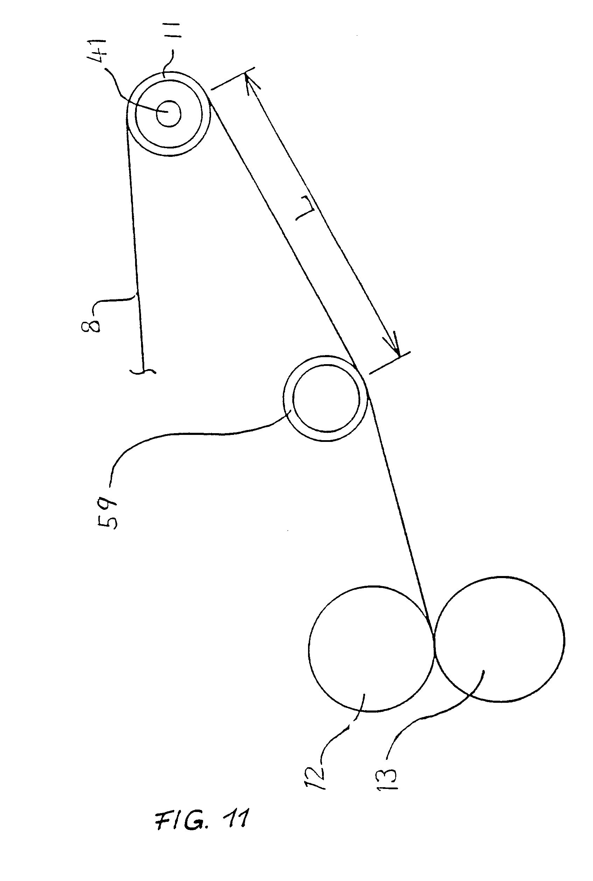

Next, the third embodiment of the present invention is explained. The embodiment has the specific feature that the photosensitive member from the heat developing to the pressure transfer is cooled so as to be below the predetermined temperature. Fig. 11 shows the basic construction of the embodiment, being a front cross-sectional view of the heat developing roller 11, the pressure transfer rollers 12 and 13 of Fig. 1.

In the drawing, the cooling of the photosensitive member 8 is performed by bringing the photosensitive member 8 in contact with the cooling roller 59 as a the cooling device which comprises a pipe type cooling roller 59 for selectively flowing the air to the inside. The hole inside the cooling roller 59 is connected to an air inlet port and an air outlet, respectively, the latter including a cooling fan. The air flows inside the cooling roller 59 by operating the cooling fan, and the cooling roller 59 is cooled, thereby the photosensitive member 8 is cooled. (The concrete construction is explained hereinafter.)

It was described above that the temperature of the photosensitive member from the heat developing to the pressure transfer generates the deterioration of the quality of the images in the image formation apparatus according to the present invention. Thereupon, the relation between the temperature of photosensitive member from the heat developing to the pressure transfer and the quality of the image is described.

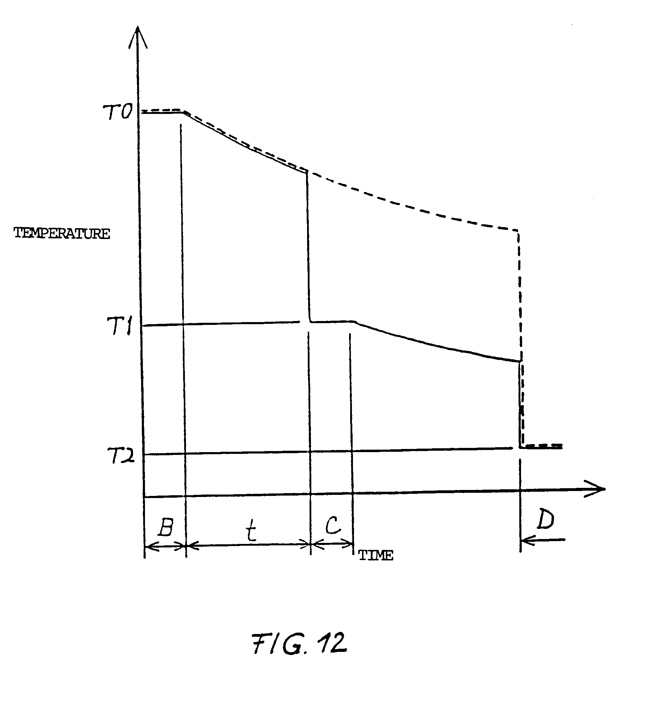

Fig. 12 is a conception view showing the temperature variation of the photosensitive member 8 according to the present invention. Figs. 11 and 12 explain the cooling condition of the present invention.

In Fig. 11, the length L is a length of the moving path from the heat developing roller of the photosensitive member 8 to the cooling roller 59. In Fig. 12, t is a moving time of the photosensitive member 8 from the heat developing roller 11 to the cooling roller 59. Further, the region B is time when the photosensitive member 8 is brought in contact with the heat developing roller 11 and is heated. The temperature TO is a temperature of the contact surface of the heat developing roller 11. The region C is a time when the photosensitive member 8 is brought in contact with the cooling roller 59 and is cooled. The temperature T1 is a temperature of the contact surface of the cooling roller 59. The region D is a time when the photosensitive member 8 is brought in contact with the pressure transfer rollers 12 and 13. The temperature T2 is a temperature of the contact surface of the pressure transfer rollers 12 and 13.

In the embodiment, the temperature TO of the heat developing roller 11 is controlled so as to be approximately 150 _{°} C for the developing reaction. The temperature T2 of the pressure transfer rollers 12 and 13 is controlled so as to be approximately 60 °C in order to stabilize the condition from the photosensitive member till the transfer member and obtain a good quality of images. However, it is not necessary to limit the temperature to the above mentioned degree. It is possible to select the heating temperature of the heat developing according to the shelf-life of the photosensitive member, the developing speed, the construction of the device, cost, and so on. It is possible to use the range of 100 to 180°C. On the contrary, it is not matter that the pressure transfer temperature is basically the room temperature. Since the viscosity of the contents of the micro capsules is lowered by heating, the transfer is easily performed. It is desirable that the temperature is 30 to 100°C in view of the several conditions as well as the heat developing temperature. Namely, the pressure transfer device of the present invention is the same as a general heat transfer device, although the pressure power and the temperature is different from each other mechanically.

When there is no cooling roller 59, the photosensitive member 8 which is heated by the heat developing roller 11 to be approximately 150°C, is cooled by the peripheral air and reaches the pressure rollers 12 and 13. Such a condition is shown by the broken line of the concept view of Fig. 12. When there is a cooling roller 59, the photosensitive member 8 is cooled by the cooling roller 59 at the temperature of T1 and the space between the heat developing roller 11 and the cooling roller 59, and the space between the cooling roller 59 and the pressure transfer rollers 12 and 13 are cooled by the peripheral air.

The inventors made experiments for output of copies of the images, the experiments being two cases, that is, one case being that there is no cooling roller 59 as a prior art and the other case being that the cooling ability of the cooling roller 59 is changed by changing the voltage applied to the cooling fan which functions for flowing the air inside the cooling roller 59.

As the method of the experiments, the cooling temperature of the cooling roller 59 is controlled by varying the force of air, and after that, the temperature of the heat developing roller 11 is controlled a little so that a good image can be obtained under the ambient temperature of 20 °C. After that, the ambient temperature is changed and one hundred papers are continuously copied. The images and the temperatures of the pressure transfer rollers 12 and 13 of the first paper and the hundredth paper were examined. Herein, the qualities of the images were functionally evaluated by four ranks, very good, substantially good, a little bad, and bad. The temperature of the pressure transfer rollers 12 and 13 is arranged at 60 °C. The moving speed of the photosensitive member 8 is 12mm/second and the length L is 60 mm and the moving time t between the time apart from the heat developing roller 11 and the time reaching the cooling roller 59 is 5 second. The result of this experiment is shown in Table 1.

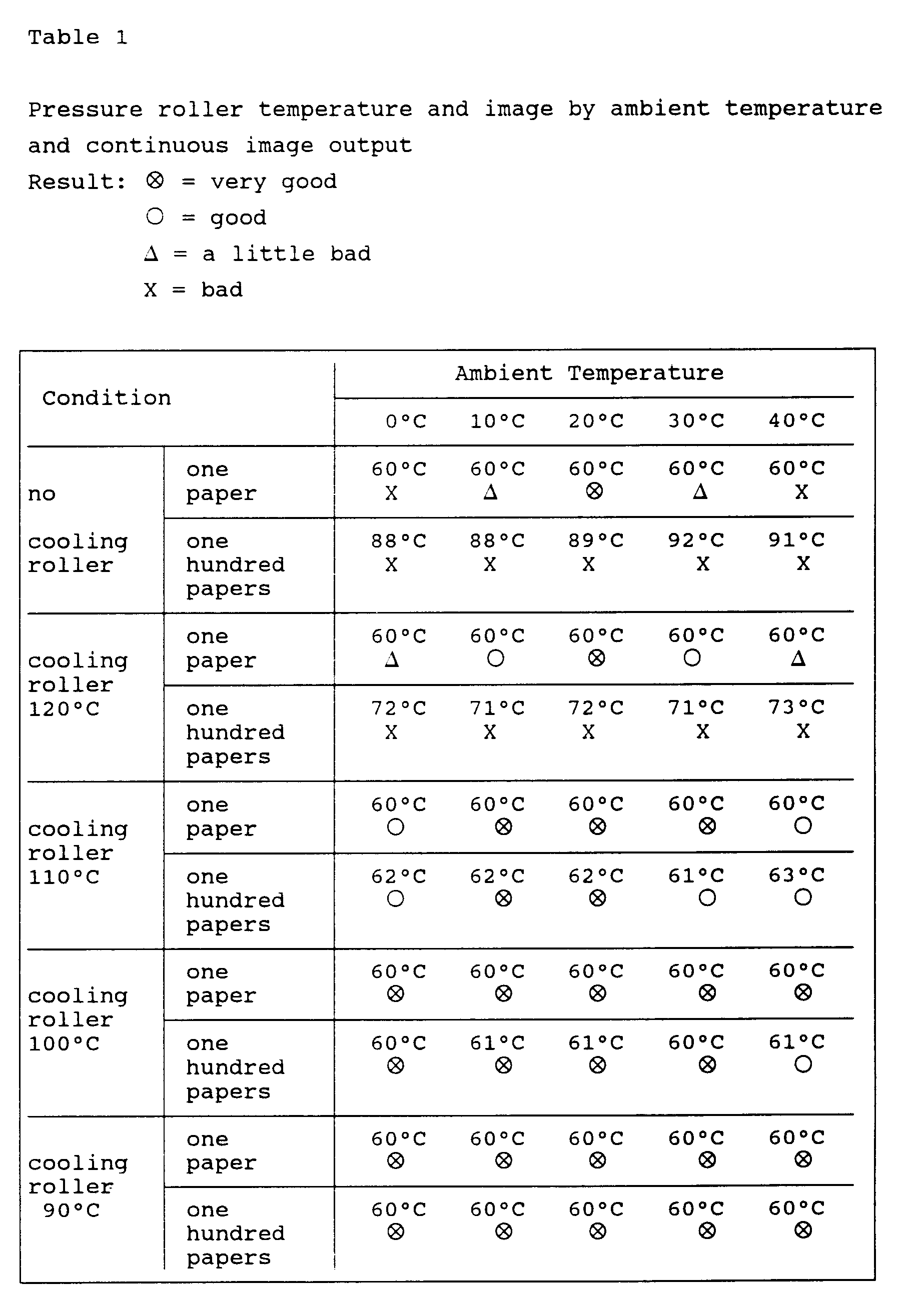

By the table 1, it is possible to reduce the heated temperature which may be generated by a continuous image output of the pressure transfer rollers 12 and 13, by sufficiently cooling the cooing roller 59. Further, it is possible to prevent the deterioration of the quality of the images, which may be generated by a continuous image output, by sufficiently cooling the photosensitive member 8 with the cooling roller 59. It is desirable that the difference between the temperature of the photosensitive member 8 and the pressure transfer rollers 12 and 13 is small, in order to prevent the temperature of the pressure transfer rollers 12 and 13 from rising. As shown in Table 1, if the temperature of the cooing roller 59 is below the temperature of the pressure transfer rollers 12 and 13 plus 50 °C, that is, below 110_{°}C, the rising temperature of the pressure transfer rollers 12 and 13 is sufficiently small and available. Further, if the temperature of the cooling roller 59 is below the temperature of the pressure transfer rollers 12 and 13 plus 30°C , that is, below 90 °C, the rising temperature of the pressure transfer rollers 12 and 13 is little recognized, and is very available.

Further, by cooling the cooling roller 59, a broader range of ambient temperatures is achieved where a good image can be obtained in spite of the change of the ambient temperature. Namely, in the Table 1, with respect to the first image output where the rising temperature of the pressure transfer rollers 12 and 13 can be neglected, when there is no cooling roller 59, the image is a little inferior under the ambient temperature of 10°C or 30°C. On the contrary, when the cooling roller 59 is used, the range where a good quality of images can be obtained is very broad, when the temperature of the cooling roller 59 is low. As shown in Fig. 12, the concept view showing the variation of the temperature, when the cooling is performed, the effect on the temperature by the surrounding air which cools the photosensitive member over the distance between the heat developing roller 11 and the pressure transfer rollers 12 and 13 becomes small, and since the moving path of the photosensitive member 8 which is kept in a high temperature is short, the heat developing reaction becomes smaller.

Further, the inventors made experiments in order to examine the range of the above effects, that is, the mounting position of the cooling roller 59 was changed. The moving time between the time when the photosensitive member 8 is apart from the heat developing roller 11 and the time when the photosensitive member comes in contact with the cooling roller 59 was changed and the images were copied under the respective ambient temperatures. Namely, the moving speed of the photosensitive member 8 was 12 mm/second and the length L was changed from 24 mm to 180 mm and the moving time t from the heat developing roller 11 to the cooling roller 59 was changed from 2 second to 15 seconds. The cooling temperature of the photosensitive member was 110°C by the cooling roller 59. The result of the experiment is shown in Table 2.

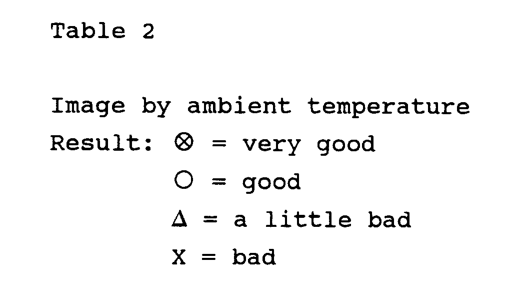

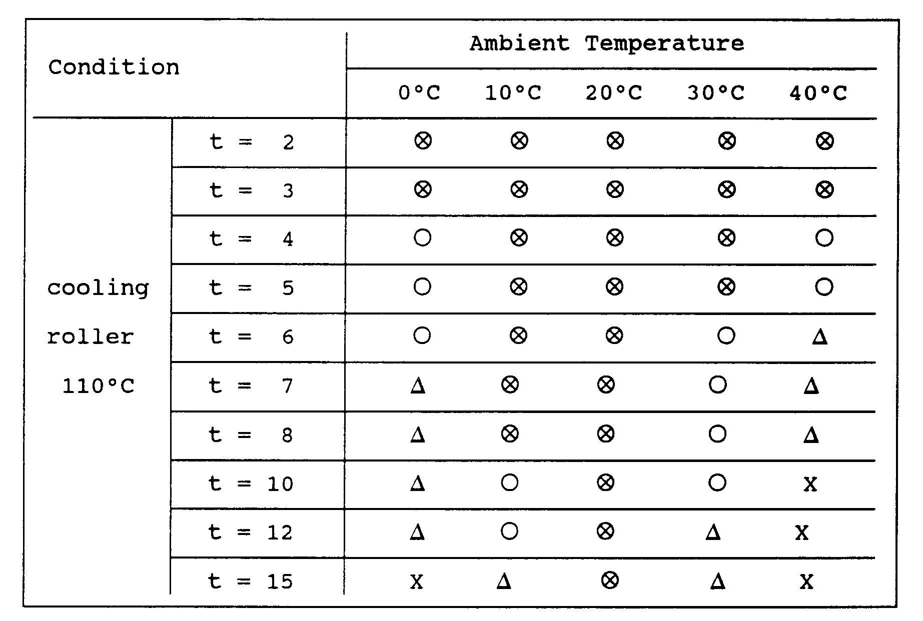

As shown in Table 2, as the moving time t from the heat developing roller 11 to the cooling roller 59 is smaller, the variation of the image is smaller according to the change of the ambient temperature. As shown in Table 2, it is desirable that the time t is below 10 seconds, in order to prevent the image from being inferior under the temperature of 10 _{°} C to 30 _{°} C which is general ambient temperature. Further, it is more desirable that the time t is 5 second or below 5 second, in order to obtain a good images. Further, if the time t is less than 3 seconds, it is possible to obtain a good images under not only a general circumstance temperature but also the range from 0 _{°} C to 40 _{°} C.

By such a construction, it is possible to obtain a stable heat developing for one uniform density of images in spite of the variety of the used condition. As a reason, the reaction speed of the heat developing reaction has a high temperature dependency and if the photosensitive member is sufficiently cooled, the reaction stops and the condition of images is not changed under the path where the temperature of the photosensitive member is not accurately controlled after heat developing reaction. Therefore, it is possible to keep the accurately controlled condition achieved in the heat image developing portion till the insertion of the pressure transfer process.

Next, with respect to the above mentioned cooling means, a concrete construction is explained.

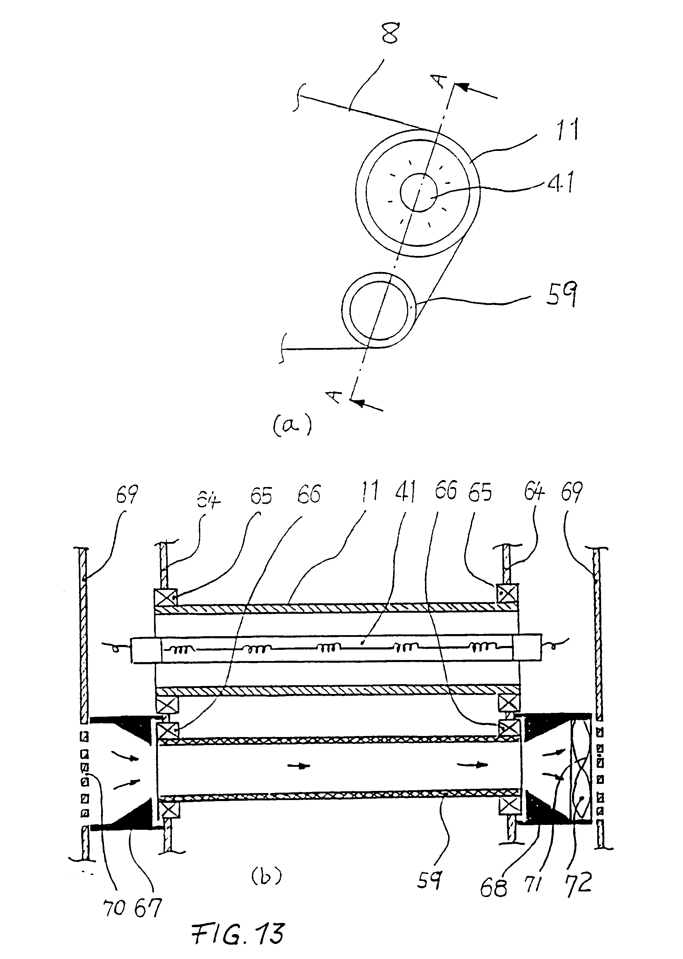

First, the cooling means of air cooling type is described. Fig. 13(a) is a front cross-sectional view of the peripheral portion of the cooling means and the heat developing device according to the third embodiment of Fig. 11. Fig. 13(b) is a A-A cross sectional view of Fig. 13(a).

In the drawing, the photosensitive member 8 rotates around the heat developing roller 11 by a predetermined amount and it is carried under tension, and is heated from the surface where the micro capsules are not coated. The heat developing roller 11 is rotatably supported by the first bearing 65 attached to a frame 64 at both ends thereof. Further, the heat developing roller 11 has a heater 41 in the cylinder thereof to appropriately control a heated amount so that a predetermined temperature is given. The cooling roller 59 is a pipe made of aluminum and is rotatably attached to the frame 64 through the second bearing 66. At the copying operation, when the photosensitive member 8 is carried, the frictional force between the photosensitive member 8 and the surface of the cooling roller 59 is stronger than the rotating resistance of the cooling roller 59, so that the cooling roller 59 is moved together with the photosensitive member 8 without any slide. A first duct 67 and a second duct 68 are attached to the frame 64 so as to oppose to openings 70 and 71 of outer case 69. There is a channel between the openings 70 and 71, and the cooling air flows toward the direction of the arrow (shown in the drawing). A fan 72 is attached to the first duct 67 and a wing of the fan 72 is rotatably driven by a motor mounted therein. The duct 73 has a substantial cone shape so that the flow resistance could become as small as possible from the cooling roller 59 to the fan 72.

The cooling roller 59 must be kept below 110°C and as a desirable temperature, the cooling roller 59 may be kept below 90 _{°} C . In order to obtain such a temperature, if a size of a general device and a fan 72 of the desirable cost is used, the inner diameter of the cooling roller 59 is desirably 5 mm or more than 5 mm. The fan 72 may always rotate. In order to reduce the noise, the fan 72 may rotate at the time of the copying operation only. The temperature of the cooling roller 59 rises till the temperature where the photosensitive member 8 can not be sufficiently cooled under the copy operating condition, because the photosensitive member 8 which is heated by the heat developing is brought in contact with the cooling roller 59 and the heat is given to the cooling roller 59 by the heated photosensitive member. While the heat is not given to the cooling roller 59 from the heated photosensitive member under the stand-by condition.

Furthermore, in order to reduce the time where the fan rotates, a temperature sensor for detecting the temperature of the cooling roller 59 may be provided to rotate the fan 72 based on the detecting temperature.

In the embodiment, the cooling roller 59 is constructed so that the cooling air does not flow in the other portion inside the device body, therefore the temperature stability of the heat developing is not prevented and the stable output of the image density can be obtained.

Stillmore, since the photosensitive member which is heated by the heat developing passes the cooling surface continuously, it is required to radiate the heat effectively. As mentioned above, if the heat is radiated from the cooling device by flowing the air effectively, it is possible to have the specific feature of the image formation apparatus of the photosensitive transfer type which is small in size and cost.

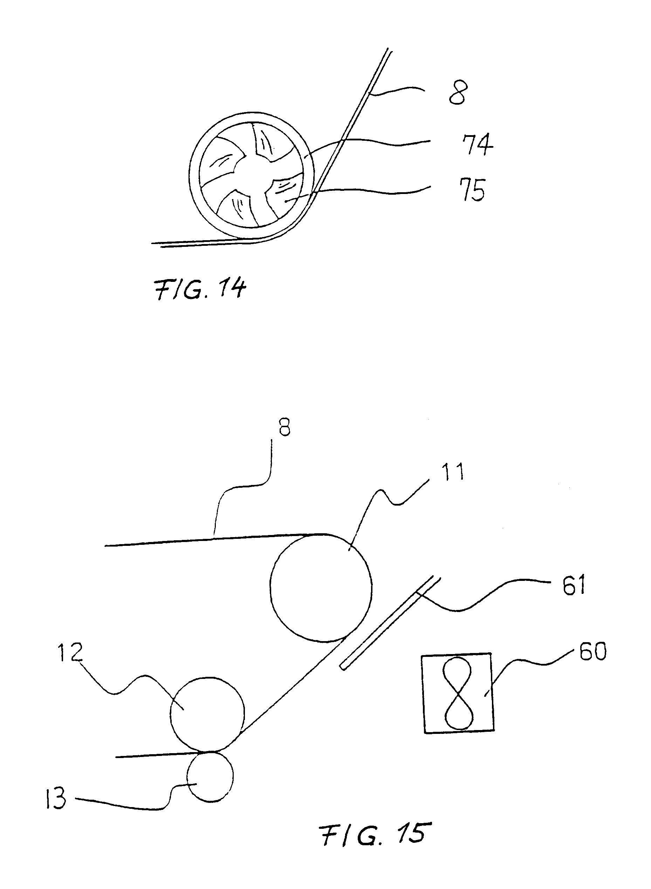

Next, an improved embodiment of Fig. 13 is explained with reference to a front cross-sectional view of Fig. 14. In the embodiment, instead of a fan, a stream of cooling air is generated by a plurality of blades 75 provided inside the cooling roller 74. The cooling roller 74 is a pipe made of aluminum and is rotatably attached to a frame (not shown) through a bearing (not shown) in the same way as that of the above mentioned embodiment.

When the photosensitive member 8 is carried at the time of the copying operation, the frictional force which acts between the photosensitive member 8 and the surface of the cooling roller 74 is stronger than that of the rotating resistance of the cooling roller 74, and the cooling roller 74 is moved together with the photosensitive member 8 without any slide. By the rotation, the plurality of blades 75 allows the air to flow inside the cooling roller 74 to remove the heat from the cooling roller 74 and radiate the heat outside. If a plurality of blades 75 are attached to a member other than the cooling roller 74 itself and the rotation of the cooling roller 74 is increased by a gear or the like to rotate the blades 75, the cooling efficiency is very high.

As a cooling method, several kinds of methods other than the above mentioned method may be used. As the other means of a air cooling type, one embodiment is described in brief.

Fig. 15 is a front cross-sectional view showing the improved embodiment of the third embodiment of Fig. 11.

In the drawing, with respect to the fan 60 which is a cooling means provided between the heat developing device and the pressure transfer device, air directly blows against the photosensitive member 8, thereby the temperature of the photosensitive member 8 is kept under 100 _{°} C in a moment. A shielding plate 61 is provided between the fan 60 and the heat developing device to prevent the air transmitted from the fan from directly blowing on the heat developing device. By such a way, it is possible to prevent the heat developing device from being cooled unnecessarily.

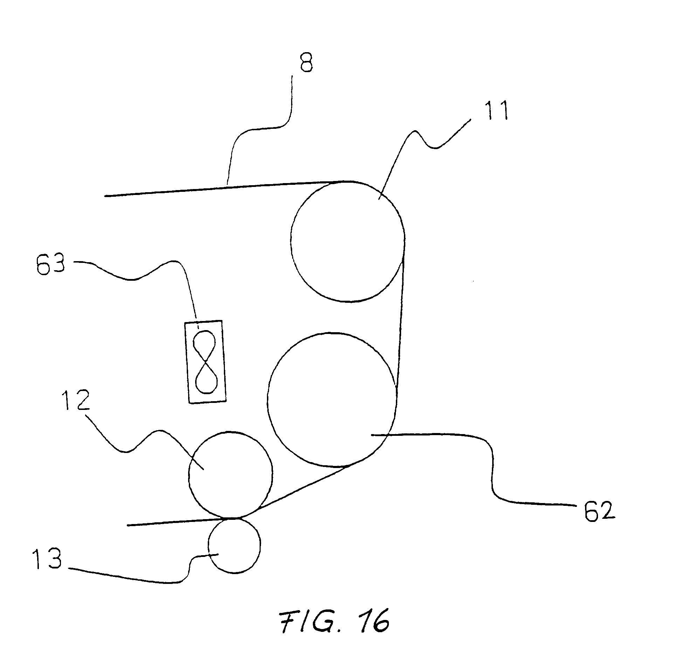

Fig. 16 is another improved embodiment and in the embodiment, heat removing roller 62 is used as a cooling means. The embodiment has the substantially same construction as that of the above mentioned second embodiment, but the temperature of the roller is forcibly cooled by the fan 63 so as to become below a predetermined temperature.

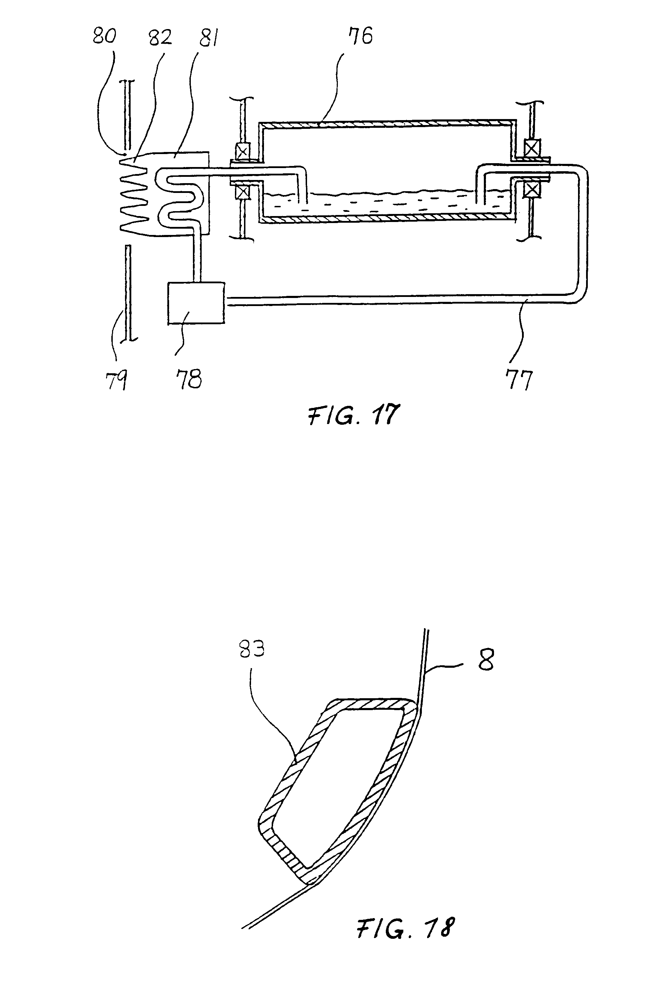

Next, an improved embodiment of the third embodiment of the image formation apparatus according to the present invention is explained with reference to the front cross-sectional view of Fig. 17. In the embodiment, as means to circulate a cooled liquid and cool the cooling roller 76, a water cooling means is used.

In the drawing, a pump 78 connected to the pipe 77 in the channel, and a radiator 81 close to the opening 80 of the outer case 79 are provided. With respect to the pump 78, the flow amount may be approximately 0.1 cc/sec or more, although it may depend on the temperature of the cooled temperature. A gear pump, a reciprocating pump or the like is used. The radiator 81 has a channel comprising a block made of aluminum so that liquid may be brought in contact with the radiator 81 for a long time, and the radiator 81 also has a plurality of fins 82 so that the surface area touching the outside air may be as broad as possible. In the embodiment, the cooling condition of the radiator 81 is accelerated by the natural convection of the air, but the radiator may be also forcibly cooled by a cooling fan. Further, the cooling liquid is forcibly circulated by the pump 78, but may be also circulated by using the natural convection.

In the embodiment, the cooling roller 76 is rotated following the moving of the photosensitive member 8 in the same way as the above mentioned embodiment. Since the pipe 77 is fixed, it is impossible to adhere the cooling roller with the pipe 77. Therefore, it is difficult to seal up the cooling liquid in the channel. In the embodiment, such a problem is eliminated by rotating the cooling roller 76. Namely, as shown in Fig. 17, the cooling liquid is injected by appropriate amount so that the liquid may not overflow the opening of the cooling roller 76.

Almost all portions of the channel are provided under the liquid surface of the cooling roller 76, therefore there is no leakage of the cooled liquid. Further, the cooled liquid is brought in contact with the whole of the inside surface of the cooling roller by rotating the cooling roller 76, therefore the cooling efficiency is the same as that of the case where the cooling roller is fully filled with liquid.

By such a construction, it is possible to simply cool the photosensitive member by the method of circulating the cooling liquid. In this case, the temperature stability of the heat developing is not prevented. Further, in the above mentioned embodiment, the cooling means is rotated together with the moving of the photosensitive member. However, besides the embodiment, other methods for bringing the photosensitive member 8 in contact with the cooling means may be also used in order to stabilize the density of images. In this case, it is not necessary that the portion corresponding to the cooling roller has a cylindrical shape, and in general, a hollow shape member may be used.

Fig. 18 shows a cross-sectional view of the cooling means as one embodiment. In the embodiment, the photosensitive member is slidably brought in contact with the top surface of the cooling plate 83, and the cooling air blows through the hollow portion in the same way as that of the above mentioned embodiment. Of course, a cooling liquid may be circulated.

Further, in the above mentioned second and third embodiments, the control of the temperature is only explained, because it was recognized that the affect of the temperature is very large. In addition, as shown in the first embodiment, the control of the humidity may be also added. Although the control mechanism is a little complex, more accurate control can be performed, and a more stable quality of images can be obtained.

Furthermore, the present invention is applicable to all photosensitive members of the heat developing type, and is not limited to the photosensitive transfer type heat developing material described in the embodiment.

Stillmore, in the embodiment, the copying machine is explained as one embodiment, but the present invention is not limited to the copying machine, and it is needless to say that it is applicable to image formation apparatus in general, such as printers, facsimile machines, and electronical cameras.

### [Industrial Applicability]

As mentioned above, the present invention is broadly applicable to the processing devices utilizing a heat developing photosensitive member. In particular, the present invention is available for use in an image formation apparatus (copying machine, printer, facsimile machine, electronical camera and so on) in that the pressure transfer is performed under a low temperature after the heat developing under a high temperature.

Further, it is possible to construct an image formation apparatus having a uniform density of the image and a high quality of output images despite the variation of the ambient temperature or the variation of the used condition of the device.

Furthermore, because of the construction for controlling the temperature of the heat developing and the heating time, the temperature differences between the respective members and the heat developing device can be compensated, and the cost of the device can be reduced.

## Claims

1. An image formation apparatus in which a photosensitive member is pressed together with a transfer member by a pressure transfer device after a heat developing type photosensitive member which was exposed by an image has been heat developed by a heat developing device, characterized by comprising means for changing at least one of the temperature and the heating time of said heat developing device, and detecting means for detecting at least one of the temperature and the humidity between said heat developing device and the pressure transfer device, wherein at least one of the temperature and the heating time is controlled by data generated from said detecting means.

2. An image formation apparatus claimed in claim 1, wherein the contacting angle between said photosensitive member and the heat developing roller is controlled to change the heating time.

3. An image formation apparatus claimed in claim 1, further comprising a heat developing device wherein the heating area is divided in several portions.

4. An image formation apparatus in which a photosensitive member is pressed together with a transfer member by a pressure transfer device after a heat developing photosensitive member which was exposed by an image has been heat developed in a heat developing device, characterized by comprising means for keeping the temperature of said photosensitive member uniform between said heat developing device and said pressure transfer device or a cooling means for keeping the temperature below a predetermined value.

5. An image formation apparatus claimed in claim 4, further comprising cooling means for cooling the photosensitive member heated by the heat developing device to a temperature below the temperature of the pressure transfer device plus 50 _{°} C.

6. An image formation apparatus claimed in claim 4, further comprising a cooling means for starting to cool the photosensitive member heated by the heat developing device within 10 seconds after completion of the heating.

7. An image formation apparatus claimed in claimed 5 or 6, comprising a cooling means including a hollow and a fan to flow cooling air in the hollow.

8. An image formation apparatus claimed in claim 7, comprising a channel so that said cooling air does not substantially affect the flow of the air near the heating portion of said heat developing device.

9. An image formation apparatus claimed in claim 8, characterized that cooling air flows at only the time of the image forming operation.

10. An image formation apparatus claimed in claim 6, further comprising a cooling means having member which is of a hollow type and generates the cooling air in said hollow portion.

11. An image formation apparatus claimed in claim 6, further comprising a cooling means which is of a hollow type, a cooling liquid being circulated in said hollow portion.

12. An image formation apparatus claimed in claim 11, characterized that the hollow type cooling roller is rotated and at the same time, the cooling liquid is filled in a part of the hollow portion.
